# FASCICULE DE BREVET EUROPEEN

(11) **EP 0 343 040 B1**
(45) Date de publication et mention de la délivrance du brevet: **27.01.1993**
(21) Numéro de dépôt: 89401301.0
(22) Date de dépôt: 10.05.1989
(51) Int. Cl.: B01D 9/00, C30B 7/00, C30B 29/58

(54) **Appareil de cristallogénèse, notamment pour vaisseau spatial**
Vorrichtung zum Kristallisieren, insbesondere für Raumschiffe
Crystallization apparatus, especially for spacecraft

(30) Priorité: 18.05.1988 FR 8806649
(43) Date de publication de la demande: 23.11.1989
(73) Titulaire: AEROSPATIALE Société Nationale Industrielle, 75781 Paris Cédex 16 (FR)
(72) Inventeur: Claramonte, Manuel Pierre, F-92370 Chaville (FR); Martin, Gérard Michel, F-59300 Valenciennes (FR); Auffret, Jean-Claude, F-78130 Chapet (FR)
(74) Mandataire: Bonnetat, Christian

(56) Documents cités:
- EP-A- 0 265 319
- EP-A- 0 282 403
- DE-A- 1 804 289
- US-A- 2 816 822

## Description

La présente invention concerne un appareil de cristallogénèse, particulièrement mais non exclusivement destiné à être utilisé à bord d'un vaisseau spatial, comportant un récipient étanche, susceptible de recevoir une substance à cristalliser, et un dispositif de distribution de deux liquides destinés à contrôler la cristallisation.

On sait que l'une des méthodes d'étude des susbstances macromoléculaires consiste à former des cristaux desdites substances et à soumettre lesdits cristaux à des examens, notamment spectrographiques.

Toutefois, les cristaux obtenus dans les laboratoires terrestres ne sont pas parfaits, tant en qualité qu'en taille, notamment à cause des phénomènes de convexion dûs à la pesanteur.

Pour remédier à cet inconvénient, il serait avantageux de pouvoir utiliser de tels appareils à bord de vaisseaux spatiaux, les conditions d'apesanteur éliminant ces phénomènes de connexion.

Cependant, le dispositif de distribution des liquides, notamment un agent précipitant et un agent diluant, dans les appareils de cristallogénèse connus, présente en fait un réservoir pour chacun des liquides intervenant dans la cristallisation, et, pour chacun de ces réservoirs, des moyens particuliers d'injection du liquide dans le récipient de cristallisation. De tels appareils présentent donc un encombrement et une masse non négligeables.

De ce fait, il est difficile d'envisager d'utiliser de tels appareils à bord de vaisseaux spatiaux, où les critères d'encombrement et de masse sont déterminants.

La présente invention a pour but d'éviter cet inconvénient, et concerne un appareil de cristallogénèse, ayant un encombrement et une masse réduits par rapport aux appareils existants, ce qui le rend particulièrement apte à être utilisé à bord d'un vaisseau spatial.

A cette fin, l'appareil de cristallogénèse, du type indiqué ci-dessus est remarquable, selon l'invention, en ce que le dispositif de distribution comprend :
- une enceinte divisée en deux chambres par un moyen de séparation déplaçable, chacune desdites chambres étant destinée à contenir un desdits liquides,
- des moyens d'alimentation en liquide reliant chacune desdites chambres audit récipient, et
- des moyens de retour de liquide, munis de moyens d'obturation sensibles à la pression, reliant ledit récipient à chacune desdites chambres,
de façon que, lorsque du liquide contenu dans une desdites chambres est amené dans ledit récipient, le trop-plein de liquide correspondant dans ledit récipient est ramené dans l'autre chambre.

Ainsi, le dispositif de distribution de l'appareil ne comprend plus qu'une enceinte unique, définissant deux chambres destinées, chacune, à recevoir un des liquides contrôlant la cristallisation. En conséquence, l'encombrement et la masse de l'appareil, selon l'invention, sont réduits par rapport aux appareils existants.

Cet effet est renforcé du fait que le liquide de trop-plein dudit récipient est ramené dans les chambres de l'enceinte, par des moyens de retour, en évitant ainsi un encombrement et une masse supplémentaires dûs à des moyens de stockage des liquides utilisés et devant être évacués à cause du trop-plein.

En outre, grâce aux moyens de retour particuliers de l'invention, les liquides contrôlant la cristallisation sont ramenés dans l'enceinte par un simple jeu de surpression et de dépression. En effet, le déplacement du moyen de séparation dans l'enceinte entraîne une surpression dans une chambre et une dépression dans l'autre chambre. Un certain volume de liquide contenu dans la chambre en surpression est, alors, injecté dans ledit récipient. En même temps, un volume identique de liquide contenu dans le récipient est ramené dans la chambre en dépression grâce aux moyens d'obturation sensibles à la pression adaptés pour cela.

Avantageusement, l'enceinte est constituée par un cylindre, et ledit moyen de séparation est un piston à double effet commandé de l'extérieur du cylindre par l'intermédiaire d'une tige de piston.

Dans un mode particulier de réalisation, il est avantageux que lesdits moyens d'alimentation soient constitués par une première conduite reliant une première chambre de l'enceinte audit récipient et par une deuxième conduite reliant la deuxième chambre de celle-ci audit récipient.

Selon ce mode particulier de réalisation, des moyens d'obturation sensibles à la pression peuvent être disposés dans chacune desdites conduites.

Préférentiellement, lesdites conduites présentent une embouchure commune dans ledit récipient, en aval des moyens d'obturation sensibles à la pression.

Selon un mode particulier de réalisation de l'invention, les moyens de retour peuvent être constitués par une conduite divisée, au voisinage desdites chambres, en deux branches dans lesquelles sont disposés les moyens d'obturation sensibles à la pression.

Il est avantageux que les moyens d'obturation sensibles à la pression soient des clapets anti-retour.

Selon une autre caractéristique de l'invention, le récipient comprend un creuset muni d'une cavité dans laquelle est disposée ladite substance à cristalliser.

De plus, des moyens d'observation, du type caméra, sont prévus pour observer la cristallisation de ladite substance.

En outre, un dispositif de commande et de traitement, du type calculateur, relié auxdits moyens d'observation, peut commander un actionneur, du type moteur, pour déplacer les moyens de séparation en fonction des informations provenant desdits moyens d'observation.

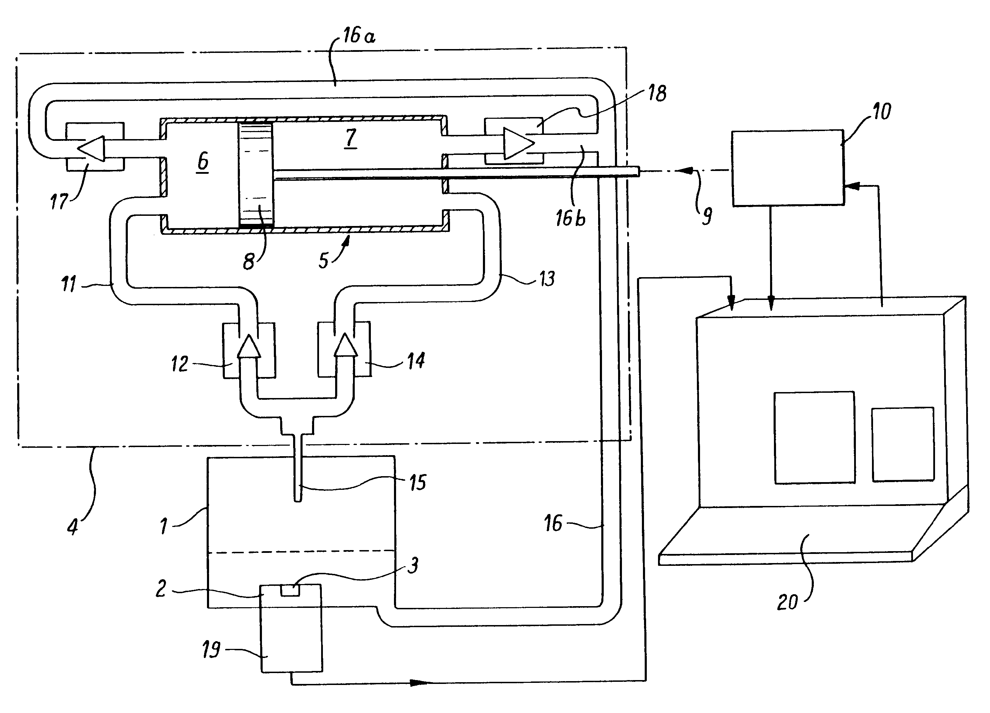

La figure unique du dessin annexe fera bien comprendre comment l'invention peut être réalisée.

Cette figure représente, schématiquement, un exemple de réalisation de l'appareil de cristallogénèse, selon l'invention.

L'appareil de cristallogénèse comprend un récipient 1 étanche, dans lequel est disposé un creuset 2 muni d'une cavité 3 destinée à recevoir la substance à cristalliser.

Le récipient 1 est alimenté en agents diluant et précipitant liquides, agents contrôlant la cristallisation, à partir d'un dispositif de distribution 4 comprenant un cylindre 5, constitué de deux chambres 6,7 pour lesdits liquides, séparées par un piston 8. En outre, le piston 8 peut être déplacé, depuis l'extérieur du cylindre 5, par l'intermédiaire d'une tige de piston 9, reliée à un moteur 10.

Par exemple, la chambre 6 peut contenir l'agent précipitant et la chambre 7, l'agent diluant.

La chambre 6 est reliée audit récipient 1 par une conduite 11, munie d'un clapet anti-retour 12. De même, la chambre 7 est reliée audit récipient 1 par une conduite 13 munie d'un clapet anti-retour 14.

Comme montré sur le dessin, les deux conduites 11,13 se rejoignent, en aval des clapets 12,14, en formant une embouchure commune 15 dans ledit récipient 1.

Par ailleurs, une conduite 16 de retour de liquide relie le récipient 1 à chacune desdites chambres 6,7. Cette conduite 16, au voisinage desdites chambres, se divise en deux branches 16a,16b, chacune desdites branches étant munie d'un clapet anti-retour 17,18, respectivement.

En outre, une caméra 19, disposée en regard du creuset 2 et de sa cavité 3, permet d'observer l'évolution de la cristallisation. Elle est reliée à un dispositif de commande et de traitement 20, analysant les informations transmises par ladite caméra 19, qui est lui-même relié au moteur 10 actionnant la tige du piston 9.

Le fonctionnement de l'invention sera décrit ci-après.

Dans l'état initial, on introduit la substance à cristalliser dans la cavité 3 du creuset 2 du récipient 1, ainsi que de l'agent précipitant, à une concentration inactive, recouvrant le creuset 2, comme indiqué en traits pointillés sur la figure.

On déplace, dans un premier temps, le piston 8 par l'intermédiaire de sa tige 9, dans le cylindre 5 du côté de la chambre 6, contenant l'agent précipitant. Une surpression est alors créée dans cette chambre 6, entraînant l'ouverture du clapet 12 dans la conduite 11 et la fermeture du clapet 14 dans la conduite 13, la chambre 7 étant en dépression. Ainsi, un certain volume d'agent précipitant est injecté dans le récipient 1.

En même temps, un volume identique de liquide contenu dans le récipient 1 est ramené par la conduite 16 et sa branche 16b dans la chambre 7 du cylindre 5, le clapet 18 étant ouvert du fait de la dépression régnant dans la chambre 7.

La caméra 19 observe l'évolution de la cristallisation et transmet les informations correspondantes au dispositif de commande et de traitement 20 qui les analyse.

S'il détermine qu'un volume de précipitant est encore nécessaire pour parachever la cristallisation, il commande le moteur 10 pour que celui-ci actionne la tige de piston 9 de façon à déplacer le piston 8 dans le cylindre 5 vers la gauche sur la figure, c'est-a-dire pour injecter un certain volume du liquide contenu dans la chambre 6.

En revanche, si le dispositif de commande 20 détermine que la zone de cristallisation a été dépassée, il commande le moteur 10 pour que celui-ci actionne la tige de piston 9 de façon à déplacer le piston 8 dans le cylindre 5 vers la droite sur la figure, en créant alors une surpression dans la chambre 7 et une dépression dans l'autre chambre 6. Un certain volume d'agent diluant est ainsi injecté dans ledit récipient 1 par la conduite 13, le clapet 14 étant ouvert par la surpression. Simultanément, un volume identique de liquide contenu dans ledit récipient 1 est ramené, par la conduite 16 et sa branche 16a, dans la chambre 6, le clapet 17 étant ouvert par la dépression régnant alors dans la chambre 6.

Il est à noter que le fait d'évacuer un certain volume de liquide, contenu dans le récipient 1, dans une des chambres ne perturbe pas le bon fonctionnement de l'appareil. En effet, la concentration en l'un ou l'autre liquide contenu dans les chambres est toujours supérieure à la concentration de ce liquide dans le récipient 1.

## Revendications

1. Appareil de cristallogénèse, notamment destiné à être utilisé à bord d'un vaisseau spatial, comportant un récipient étanche, susceptible de recevoir une substance à cristalliser, et un dispositif de distribution de deux liquides destinés à contrôler la cristallisation, caractérisé en ce que le dispositif de distribution (4) comprend :
- une enceinte divisée en deux chambres (6,7) par un moyen de séparation déplaçable (8), chacune desdites chambres (6,7) étant destinée à contenir un desdits liquides,
- des moyens d'alimentation en liquide (11,13) reliant chacune desdites chambres (6,7) audit récipient (1), et
- des moyens de retour de liquide (16), munis de moyens d'obturation (17,18) sensibles à la pression, reliant ledit récipient (1) à chacune desdites chambres (6,7),
de façon que, lorsque du liquide contenu dans une desdites chambres (6 ou 7) est amené dans ledit récipient (1), le trop plein de liquide correspondant dans ledit récipient (1) est ramené dans l'autre chambre (6 ou 7).

2. Appareil de cristallogénèse selon la revendication 1, caractérisé en ce que l'enceinte est constituée par un cylindre (5), et en ce que ledit moyen de séparation (8) est un piston à double effet commandé de l'extérieur du cylindre par l'intermédiaire d'une tige de piston (9).

3. Appareil de cristallogénèse selon la revendication 1 ou la revendication 2,
caractérisé en ce que lesdits moyens d'alimentation (11,13) sont constitués par une première conduite (11) reliant une première chambre (6) de l'enceinte audit récipient (1) et par une deuxième conduite (13) reliant la deuxième chambre (7) de celle-ci audit récipient (1).

4. Appareil de cristallogénèse selon la revendication 3, caractérisé en ce que des moyens d'obturation (12,14) sensibles à la pression sont disposés dans chacune desdites conduites (11,13).

5. Appareil de cristallogénèse selon la revendication 3 ou la revendication 4,
caractérisé en ce que lesdites conduites (11,13) présentent une embouchure (15) commune dans ledit récipient (1), et en ce que les moyens d'obturation (12,14) sensibles à la pression sont situés en amont de ladite embouchure (15).

6. Appareil de cristallogénèse selon l'une quelconque des revendications 1 à 5,
caractérisé en ce que les moyens de retour (16) sont constitués par une conduite divisée, au voisinage desdites chambres (6,7), en deux branches (16a,16b) dans lesquelles sont disposés les moyens d'obturation (17,18) sensibles à la pression.

7. Appareil de cristallogénèse selon la revendication 4 ou la revendication 6,
caractérisé en ce que les moyens d'obturation (12, 14,17,18) sensibles à la pression sont des clapets anti-retour.

8. Appareil de cristallogénèse selon l'une quelconque des revendications 1 à 7,
caractérisé en ce que le récipient (1) comprend un creuset (2) muni d'une cavité (3) dans laquelle est disposée ladite substance à cristalliser.

9. Appareil de cristallogénèse selon l'une quelconque des revendications 1 à 8,
caractérisé en ce que des moyens d'observation (19), du type caméra, sont prévus pour observer la cristallisation de ladite substance.

10. Appareil de cristallogénèse selon la revendication 9, caractérisé en ce qu'un dispositif de commande et de traitement (20), du type calculateur, relié auxdits moyens d'observation (19) peut commander un actionneur (10), du type moteur, pour déplacer les moyens de séparation (8) en fonction d'informations provenant desdits moyens d'observation (19).

## Patentansprüche

1. Vorrichtung zum Kristallisieren, insbesondere zur Benutzung an Bord eines Raumschiffes, mit einem dichten Behälter zum Aufnehmen einer zu kristallisierenden Substanz und einer Vorrichtung zum Verteilen von zwei zur Kontrolle der Kristallisierung vorgesehenen Flüssigkeiten,
dadurch gekennzeichnet, daß die Vorrichtung zum Verteilen (4) umfaßt:
- eine mittels eines verschiebbaren Trennmittels (8) in zwei Kammern (6, 7) aufgeteilte Einfassung, wobei jeder der beiden Kammern (6, 7) zum Aufnehmen einer der besagten Flüssigkeiten vorgesehen ist,
- Versorgungsmittel (11, 13) zum Versorgen mit Flüssigkeit, die jede der besagten Kammern (6, 7) mit dem besagten Behälter (1) verbinden, und
- Rückführmittel (16) zum Rückführen der Flüssigkeit, versehen mit auf Druck ansprechenden Verschließmitteln (17, 18), die den besagten Behälter (1) mit jeder der besagten Kammern (6, 7) verbinden,
sodaß, wenn in einer der besagten Kammern (6 oder 7) enthaltene Flüssigkeit in den besagten Behälter geführt wird, der entsprechende Überschuß an Flüssigkeit im besagten Behälter (1) in die andere Kammer (6 oder 7) zurückgeführt wird.

2. Vorrichtung zum Kristallisieren nach Anspruch 1, dadurch gekennzeichnet, daß die Einfassung aus einem Zylinder (5) besteht und daß das besagte Trennmittel (8) ein von außerhalb des Zylinders über eine Kolbenstange (9) gesteuerter Scheibenkolben ist.

3. Vorrichtung zum Kristallisieren nach Anspruch 1 oder 2,
dadurch gekennzeichnet, daß die Versorgungsmittel (11, 13) aus einer ersten, eine erste Kammer (6) der Einfassung mit dem besagten Behälter (1) verbindenden Leitung (11) und aus einer zweiten, deren zweite Kammer (7) mit dem besagten Behälter (1) verbindenden Leitung (13) besteht.

4. Vorrichtung zum Kristallisieren nach Anspruch 3, dadurch gekennzeichnet, daß die auf Druck ansprechenden Verschließmittel (12, 14) in jeder der besagten Leitungen (11, 13) angeordnet sind.

5. Vorrichtung zum Kristallisieren nach Anspruch 3 oder 4,
dadurch gekennzeichnet, daß die besagten Leitungen (11, 13) eine gemeinsame Mündung (15) im besagten Behälter (1) aufweisen und daß die Verschließmittel (12, 14) sich vor der besagten Mündung (15) befinden.

6. Vorrichtung zum Kristallisieren nach einem der Ansprüche 1 bis 5,
dadurch gekennzeichnet, daß die Rückführmittel (16) aus einer in der Nähe der besagten Kammern (6, 7) in zwei Zweige (16a, 16b) aufgeteilten Leitung bestehen, in denen die auf Druck ansprechenden Verschließmittel (17, 18) angeordnet sind.

7. Vorrichtung zum Kristallisieren nach Anspruch 4 oder 6,
dadurch gekennzeichnet, daß die auf Druck ansprechenden Verschließmittel (12, 14, 17, 18) Rückschlagventile sind.

8. Vorrichtung zum Kristallisieren nach einem der Ansprüche 1 bis 7,
dadurch gekennzeichnet, daß der Behälter (1) einen mit einem Hohlraum (3) versehenen Tiegel (2) aufweist, in dem die zu kristallisierende Substanz aufgenommen ist.

9. Vorrichtung zum Kristallisieren nach einem der Ansprüche 1 bis 8,
dadurch gekennzeichnet, daß Beobachtungsmittel (19) vom Kamera-Typ zur Beobachtung der Kristallisation der besagten Substanz vorgesehen sind.

10. Vorrichtung zum Kristallisieren nach Anspruch 9, dadurch gekennzeichnet, daß eine mit den besagten Beobachtungsmitteln (19) verbundene Steuer- und Bearbeitungsvorrichtung (20) vom Rechner-Typ einen Betätiger (10) vom Motor-Typ steuern kann, um die Trennmittel (8) in Abhängigkeit von aus den besagten Beobachtungsmitteln (19) erhaltenen Informationen zu verschieben.

## Claims

1. Crystal-growth apparatus, especially intended to be used on board a spacecraft, comprising a sealed receptacle, capable of holding a substance to be crystallised, and a device for delivering two liquids intended to regulate the crystallisation, characterised in that the delivering device (4) comprises:
- an enclosure divided into two chambers (6, 7) by a movable separation means (8), each of the said chambers (6, 7) being intended to contain one of the said liquids,
- liquid-supply means (11, 13) connecting each of the said chambers (6, 7) to the said receptacle (1), and
- liquid-return means (16), fitted with pressure-sensitive obturation means (17, 18), connecting the said receptacle (1) to each of the said chambers (6, 7), so that, when some of the liquid contained in one of the said chambers (6 or 7) is brought into the said receptacle (1), the corresponding excess of liquid in the said receptacle (1) is brought back into the other chamber (6 or 7).

2. Crystal-growth apparatus according to Claim 1, characterised in that the enclosure is constituted by a cylinder (5), and in that the said separation means (8) is a double-acting piston controlled from outside the cylinder via a piston rod (9).

3. Crystal-growth apparatus according to Claim 1 or Claim 2,
characterised in that the said supply means (11, 13) are constituted by a first pipe (11) connecting a first chamber (6) of the enclosure to the said receptacle (1) and by a second pipe (13) connecting the second chamber (7) of the enclosure to the said receptacle (1).

4. Crystal-growth apparatus according to Claim 3, characterised in that pressure-sensitive obturation means (12, 14) are disposed in each of the said pipes (11, 13).

5. Crystal-growth apparatus according to Claim 3 or Claim 4,
characterised in that the said pipes (11, 13) present a common opening (15) in the said receptacle (1), and in that the pressure-sensitive obturation means (12, 14) are situated upstream from the said opening (15).

6. Crystal-growth apparatus according to any one of Claims 1 to 5,
characterised in that the return means (16) are constituted by a pipe which is divided, in the vicinity of the said chambers (6, 7), into two branches (16a, 16b) in which the pressure-sensitive obturation means (17, 18) are disposed.

7. Crystal-growth apparatus according to Claim 4 or Claim 6,
characterised in that the pressure-sensitive obturation means (12, 14, 17, 18) are non-return valves.

8. Crystal-growth apparatus according to any one of Claims 1 to 7,
characterised in that the receptacle (1) comprises a dish (2) fitted with a cavity (3) in which the said substance to be crystallised is disposed.

9. Crystal-growth apparatus according to any one of Claims 1 to 8,
characterised in that observation means (19), of the camera type, are provided in order to observe the crystallisation of the said substance.

10. Crystal-growth apparatus according to Claim 9, characterised in that a control and processing device (20), of the computer type, connected to the said observation means (19) may control an actuator (10), of the motor type, in order to move the separation means (8) according to the information coming from the said observation means (19).
